# EUROPEAN PATENT APPLICATION

(11) **EP 4 357 479 A1**
(43) Date of publication of application: **24.04.2024**
(21) Application number: 22824911.6
(22) Date of filing: 09.06.2022
(51) Int. Cl.: C23C 14/02, H05F 3/02, H05F 3/04

(54) **METHOD FOR MANUFACTURING PROCESSED PLASTIC FILM**

(30) Priority: 14.06.2021 JP 2021098726
(71) Applicant: TOYOBO CO., LTD., Osaka-shi, Osaka 530-0001 (JP)
(72) Inventor: ISEKI, Kiyoshi, Inuyama-shi, Aichi 484-8508 (JP)
(74) Representative: Vossius & Partner Patentanwälte Rechtsanwälte mbB
(86) International application number: PCT/JP2022/023329
(87) International publication number: WO 2022/264921

(57) **Abstract**

[Problem] To provide a method for manufacturing a processed plastic film, the method comprising a charge removal step for preventing damage to a charged plastic film due to abnormal discharge and eliminating problems with plastic film travel due to electrostatic adhesion by removing the charge on the plastic film using a simple device and lowering the potential at the surface.

[Solution] The problem can be solved by a method which is for manufacturing a processed plastic film and reduces the amount of charge on a plastic film traveling in a vacuum, the method comprising a step (step 1) for removing charge by a charge removal method in which a conductor having a radius of curvature of 1 mm or less is installed near the plastic film in the width direction of the plastic film, the shortest distance between the surface of the plastic film and the conductor is set to 2-10 mm, and the grounded conductor is used while maintaining the pressure therebetween at 8-800 Pa.

## Description

### TECHNICAL FIELD

The present invention relates to a method for manufacturing a processed plastic film, which includes a step of removing an electric charge carried by a plastic film running in a vacuum.

### BACKGROUND ART

Laminated films such as magnetic recording tapes, ITO films, aluminum vapor-deposited films, and transparent vapor-deposited films, which are plastic films laminated with inorganic substances, are commercially available. These laminated films are manufactured using sputtering and vacuum deposition techniques. In the manufacture of these, a method is generally used in which a long plastic film is put into a vacuum device as a roll, and the plastic film is unwound and run in a vacuum to be laminated with an inorganic thin film layer (for example, see Patent Document 1) .

When plastic films are unwound or run using rolls and the like, the plastic films are electrically charged by peeling electrification, frictional electrification, and the like. When the potential increases by a large quantity of electric charge, an electric discharge occurs and the plastic film surface is destroyed, or the electricity is released to nearby conductors and holes are formed in the plastic films.

By electrical charge, the plastic film is electrostatically attracted to the roll that is in contact with the plastic film and wound around the roll, leading to a running failure.

Therefore, electric charge removing devices are installed to remove the electric charge. For example, there is an ion generator or a stainless steel fiber electrostatic brush that is grounded to the unwound plastic film and brought as close as 1 mm to the plastic film. (See, for example, Patent Document 1).

There is also a method in which the electric charge is removed by spraying gas onto the electrically charged plastic film. (See, for example, Patent Document 2)

There is also a method in which the electric charge is removed from the plastic film by applying a direct current or alternating current voltage to the electrodes and adjusting the pressure to generate glow discharge. (See, for example, Patent Document 3)

In a case where the electrostatic brushes are installed within 1 mm as described in Patent Document 1, problems are less likely to occur when the plastic film is run at low speeds (for example, 10m/min), but the plastic film vibrates and comes into contact with the electrostatic brush, getting scratches when the plastic film is run at high speeds (for example, 100 m/min).

Generally, in a high vacuum, the electric field is concentrated and an electric charge does not move to space unless a high voltage is applied. In the presence of gas, the state of electric discharge changes depending on the pressure region, arc discharge occurs at relatively high pressures, and the plastic film is damaged. The electric discharge starting voltage also changes depending on the distance between the electrodes and the shape of the electrodes. Therefore, in the method of simply spraying gas as described in Patent Document 2, the electric charge may not be removed or arc discharge may rather occur and the plastic film may be damaged.

The electric charge removal by glow discharge described in Patent Document 3 is a method in which the electric charge is removed by plasma generated by glow discharge, and the electric charge is removed using electrons and ions present in the plasma. Ions that have moved to the boundary region within the plasma are accelerated by the potential difference between the boundary region of the plasma and the surface of the plastic film, and bond with the electrons to be neutralized in a case where the surface of the plastic film is charged with electrons. Therefore, the ions are completely neutralized when being exposed to plasma for a sufficient period of time.

However, as the running speed of the plastic film increases, the peeling electrification and frictional electrification of the plastic film increase, but the time of exposure of the plastic film to the plasma decreases, making it impossible to remove the electric charge sufficiently.

There is sputtering as a method for forming an inorganic thin film layer on a plastic film. In this method, the raw material of the film to be created is created as a target, plasma is generated, and ions are bombarded with the target placed at a negative potential to knock out the atoms and molecules of the raw material, and the atoms and molecules are deposited on the plastic film. The thin film formation speed in this method is generally several m/min, and the quantity of electric charge is relatively small. Electrical charge decreases by the exposure to plasma as well.

Another method is chemical vapor deposition (CVD), in which a raw material gas is introduced between electrodes and plasma is generated to chemically change the gas and form a film. In this method, the speed of the plastic film is usually several tens of m/min, and since the plastic film runs through plasma, the quantity of electric charge is small.

The vacuum deposition method is a method in which the raw material of the film is evaporated by raising the temperature to form a film on a plastic film, and the plastic film is subjected to manufacture at a running speed of several hundreds of m/min. For this reason, the quantity of electric charge is larger than those in other methods. Among others, the electron beam heating vapor deposition method, in which the raw material is heated and evaporated by being irradiated with an electron beam, a portion of the electron beam rebounds from the raw material, or secondary electrons are generated so that a large number of electrons is charged on the plastic film during vapor deposition.

Compared to inorganic substance lamination methods by sputtering and CVD, in the vapor deposition method, the quantity of electric charge increases, making it more difficult to remove the electric charge. In the vapor deposition method using electron beams, existing electric charge removing methods may lack electric charge removing ability.

### PRIOR ART DOCUMENT

### PATENT DOCUMENTS

Patent Document 1: JP-A-2-281420
Patent Document 2: JP-A-2000-54151
Patent Document 3: JP-A-62-56567

### SUMMARY OF THE INVENTION

### PROBLEMS TO BE SOLVED BY THE INVENTION

The present invention has been devised in view of the problems of the conventional techniques. In other words, an object of the present invention is to provide a method for manufacturing a processed plastic film, which includes an electric charge removing step for preventing damage to a plastic film due to abnormal electric discharge and eliminating problems with plastic film running due to electrostatic adhesion by removing an electric charge carried by the plastic film using a simple device and lowering a surface potential.

### MEANS FOR SOLVING THE PROBLEMS

As a result of intensive studies, the present inventors have found that the above problems can be solved by the following means, and have reached the present invention. In other words, the present invention has the following configurations.

The present invention is a method for manufacturing processed plastic, which includes a step (step 1) of removing an electric charge by an electric charge removing method in which a conductor having a radius of curvature of 1 mm or less is installed in a transverse direction of a plastic film near the plastic film, a shortest distance between a plastic film surface and the conductor is set to 2 mm or more and 10 mm or less, a pressure between the plastic film surface and the conductor is kept at 8 Pa or more and 800 Pa or less, and the grounded conductor is used as a method for reducing a quantity of electric charge of a plastic film running in a vacuum.

The present invention is a method for manufacturing processed plastic, which includes a step (step 2) of removing an electric charge from the plastic film by installing a device that connects a negative potential or an alternating current potential with a high frequency to a plate electrode, allows gas to flow between the plate electrode and the plastic film to generate plasma, and removes an electric charge by the generated plasma subsequently to the step 1.

The present invention is a method for manufacturing processed plastic, which includes a step of installing a metal roll on a side of the plastic film opposite to a side on which the conductor is installed, grounding the metal roll, and removing an electric charge while running the plastic film over the metal roll.

The present invention is a method for manufacturing a processed plastic film, which includes the step in a manufacturing method for providing a vapor-deposited layer on a plastic film.

### EFFECT OF THE INVENTION

According to the present invention, it is possible to remove the electric charge carried by a plastic film, and to prevent damage to the plastic film due to unintentional arc discharge by bringing the surface potential close to the grounding potential. It is also possible to avoid running problems caused by winding of the plastic film around the roll during running due to electrostatic adhesion.

### BRIEF DESCRIPTION OF THE DRAWINGS

Fig. 1 is a schematic diagram of an example of an electric charge removing device.
Fig. 2 illustrates an example of a tip portion of a conductor.
Fig. 3 illustrates an example of a tip portion of a conductor; square shape.
Fig. 4 illustrates an example of a conductor: comb shape.
Fig. 5 illustrates an example of a tip portion of a comb-shaped conductor.
Fig. 6 illustrates an example of a tip portion of a comb-shaped conductor.
Fig. 7 illustrates an example of a tip portion of a comb-shaped conductor.
Fig. 8 illustrates an example of installation of a conductor on a roll.
Fig. 9 illustrates an example of a manufacturing method using an electric charge removing method (electron beam vapor deposition by roll-to-roll).
Fig. 10 illustrates an example of combination of an electric charge removing method using a conductor and a subsequent electric charge removing method by plasma generated using a plate electrode.

### MODE FOR CARRYING OUT THE INVENTION

The manufacturing method of the present invention is a method for manufacturing a processed plastic, which includes a step of installing a grounded conductor having a radius of curvature of 1 mm or less in a constant pressure near the plastic film to remove an electric charge as a method for reducing the quantity of electric charge of a plastic film running in a vacuum.

In the present invention, the plastic film is a plastic film obtained by melt-extruding an organic polymer and performing stretching in the machine direction and/or the transverse direction, cooling, and heat setting if necessary. Examples of the organic polymer include polyethylene, polypropylene, polyethylene terephthalate, polyethylene-2,6-naphthalate, nylon 6, nylon 4, nylon 66, nylon 12, polyvinyl chloride, polyvinylidene chloride, polyvinyl alcohol, wholly aromatic polyamide, polyamide imide, polyimide, polyether imide, polysulfone, polyphenylene sulfide, and polyphenylene oxide. These organic polymers may be copolymerized or blended with a small amount of other organic polymers.

Because of recent global environmental issues, it is also possible to use organic polymers in which organic polymers produced using biomass-derived organic substances partly or wholly are used partly or wholly.

Furthermore, the plastic film may be subjected to surface treatment such as corona treatment.

Furthermore, a laminated body formed by laminating different organic substances into one body is also called a plastic film. A laminated body formed by coating a plastic film with other organic substances and laminating these is also called a plastic film. A laminated body formed by coating a plastic film or a laminated body formed by coating a plastic film with an organic substance with an inorganic substance including a metal layer such as aluminum or a metal oxide such as ITO or aluminum oxide and laminating these is also called a plastic film. The thickness of the plastic film in the present invention is preferably in the range of 5 to 500 um, more preferably in the range of 8 to 300 µm.

In the present invention, the processed plastic film refers to a plastic film processed by laminating an organic layer or an inorganic layer on the plastic film, or by treating the surface with plasma or the like to change the physical properties of the surface.

A conductor (1), which is a conductor having a radius of curvature of 1 mm or less, of the present invention refers to one obtained by molding a conductive substance such as metal or carbon having a conductivity of 1 × 10³ S/m or more. The conductor (1) also refers to resins to which conductivity is imparted by kneading these conductive substances in the form of fibers or powders and resins and the like together, and those formed by laminating a metal layer or a carbon layer on the surface of resins and molding the laminated bodies.

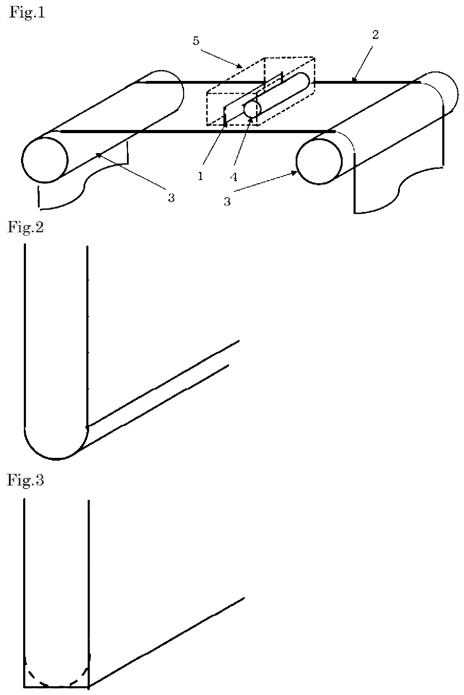

For example, in the case of the conductor (1) for electric charge removal installed in Fig. 1, the radius of curvature of 1 mm or less in the present invention means that the tip portion of the conductor on the side facing the plastic film (2) waits for a tip of a surface having a radius of curvature smaller than a circle having a radius of 1 mm as illustrated in Fig. 2. The surface whose radius of curvature is being determined is the surface that takes the minimum radius of curvature when viewed in cross section on an arbitrary surface passing through the tip.

The tip portion may be a tip having a corner having a radius of curvature smaller than a circle having a radius of 1 mm illustrated by the dotted line in Fig. 3.

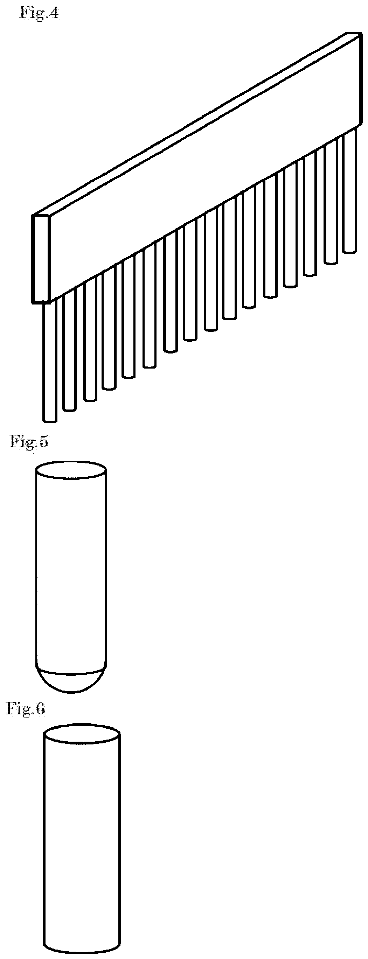

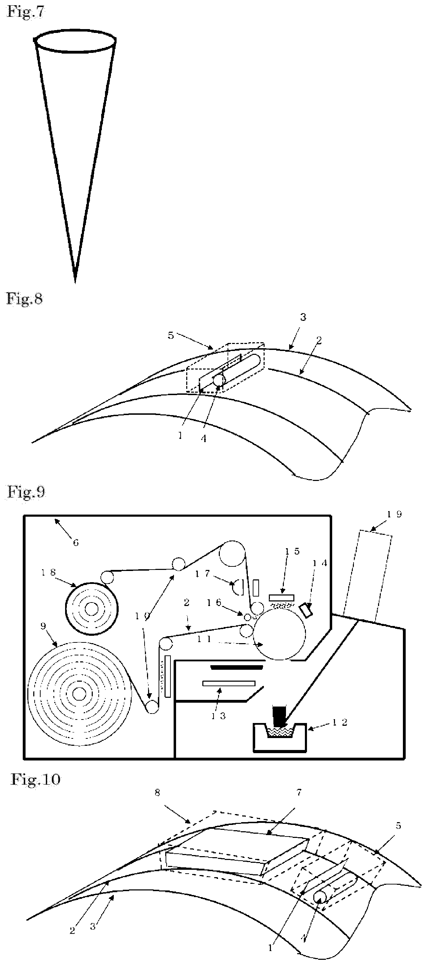

In a case where the conductor has a comb or brush shape as illustrated in Fig. 4, and the tip of the part corresponding to the teeth of the comb or the part corresponding to the bristles of the brush has the shape illustrated in Fig. 5, the minimum value of the radius of curvature determined in an arbitrary cross section passing through the tip is 1 mm or less. The shape is not particularly limited as illustrated in Figs. 6 and 7, and may be any shape as long as it has a tip having a value of the radius of curvature of 1 mm or less.

The radius of curvature is preferably 1 mm or less. In a case where the radius of curvature exceeds 1 mm, the lines of electric force from the electric charge carried by the plastic film are less concentrated in the conductor, and the force to ionize the gas and extract the electric charge is insufficient.

As a specific conductor that satisfies the conductor (1) of the present invention, for example, a copper strip having a thickness of 1 mm or less, or a line of thin carbon or metal threads that are generally commercially available as electric charge removing brushes, or an electric charge removing cloth of a fabric obtained by weaving organic fibers and metal threads or the like or a fabric obtained by weaving fibers laminated with a conductive substance can be used.

In the present invention, "installing in the transverse direction of the plastic film (2)" means installing so as to cover the entire width or substantially the entire width of the plastic film (2), as illustrated in Fig. 1.

In the present invention, setting the shortest distance between the surface of the plastic film (2) and the conductor (1) to 2 mm or more and 10 mm or less means that the normal line that substantially passes through the tip of the conductor (1) and binds the surface of the plastic film (2), the length from the tip to the surface of the plastic film (2) is 2 mm or more and 10 mm or less. When the shortest distance is closer than 2 mm, the running plastic film vibrates and comes into contact with the conductor, getting scratches and tears. On the other hand, when the distance is wider than 10 mm, the potential gradient between the plastic film and the conductor becomes gentle, and the force to ionize the gas and extract the electric charge is insufficient.

As a method for maintaining the distance between the surface of the running plastic film and the conductor, there is a method in which the surface position of the plastic film is fixed and the distance from the conductor is maintained by running the plastic film in a state where tension is applied between at least two rolls (3) as illustrated in Fig. 1. However, there is a case where it is difficult to maintain the distance since wrinkles are generated by the flatness and the thickness uniformity in thin plastic films of 25 µm or less.

As a preferable method, there is a method in which the plastic film (2) is run on the metal roll (3) and the conductor (1) is installed on the surface opposite to the surface on which the metal roll (3) is installed to maintain the distance between the conductor (1) and the plastic film (2) as illustrated in Fig. 8.

In the present invention, the pressure refers to the pressure in the space between the tip of the conductor and the plastic film. The pressure may be maintained by residual gas, but usually gas is introduced from the outside to adjust the pressure. It is preferable to mainly introduce argon as the gas to adjust and maintain the pressure.

A pressure of about 1 Pa is required to acquire an electric charge removing effect, but a pressure of 8 Pa or more is required to acquire a more preferable electric charge removing effect. It is not preferable that the pressure is 800 Pa or more since the electric charge removing effect by self discharge begins to drop.

In the case of introducing gas from the outside, it is preferable to install a nozzle (4) near the conductor to blow the gas into between the tip of the conductor (1) and the plastic film (2). The pressure between the conductor and the plastic film can be efficiently adjusted. Furthermore, it is preferable to surround the conductor (1) and the nozzle (4) with a wall (5). It is also possible to reduce pressure increases at other parts as well as to adjust the pressure more efficiently. It is preferable that the wall (5) is a metal or another conductive material and is grounded.

It is preferable that the metal roll (3) installed on the side of the plastic film opposite to the side on which the conductor (1) is installed is also grounded by connecting a wire to a vacuum chamber (6) that is grounded or a metal structure in the vacuum chamber that is at grounding potential.

By the electric charge removing method of the present invention, the electric charge carried by the plastic film (2) can be efficiently removed. It is possible to prevent hindrance due to discharge of carried electric charge, winding around the rolls, and the like. However, since the electric charge removal is performed using the potential difference between the grounding potential of the conductor and the electric charge, the electric charge carried by the plastic film cannot be removed to the grounding potential. Therefore, it is preferable to include a step (step 2) of removing an electric charge by installing a device that connects a negative potential or an alternating current potential with a high frequency to a plate electrode (7), allows gas to flow under the plate electrode (7) to generate plasma, and removes an electric charge by the generated plasma subsequently to the electric charge removal by a grounded conductor as illustrated in Fig. 10.

The plate electrode (7) is preferably formed of a material that is hardly sputtered by ions in plasma, such as titanium or stainless steel among metals. Carbon exhibiting conductivity is also preferable. Plasma contributing to electric charge removal is generated by substantially maintaining the plate electrode (7) at a negative potential. As the most commonly used method, there is a method in which the potential is lowered using a direct current power supply, or a method in which an alternating current potential of a high frequency called RF is applied to acquire a substantially negative potential. The reference of potential is grounding potential.

In order to stably generate plasma, it is preferable to use a magnetron method in which electrons are confined near the electrode using a magnetic field. The magnetic field can be created by installing a magnet or the like on the opposite surface to the surface where plasma is generated of the plate electrode. In order to efficiently create a confinement magnetic field, the plate electrode (7) is preferably formed of a nonmagnetic material. In terms of this condition as well, the plate electrode (7) is preferably formed of a nonmagnetic metal such as titanium or stainless steel, or carbon.

Since the plate electrode (7) is heated by plasma, it is preferable to cool the plate electrode (7).

Argon gas is preferable as the gas for generating plasma. It is preferable to surround the plate electrode (7) with a wall (8) to stabilize the pressure. The pressure is preferably in the range of 0.1 Pa to 10 Pa.

The plate electrode (7) has a plate shape, but may be curved to maintain a constant distance from the roll (5) in the case of being installed on the roll (5).

As an example of the manufacturing method using this electric charge removing method, there is manufacture of a transparent alumina barrier film by an electron beam heating type vapor deposition method. A transparent alumina barrier film is a plastic film in which an aluminum oxide layer is laminated on polyethylene terephthalate (PET), polyamide resin, or the plastic film (2) commonly called nylon (Ny) to impart barrier properties.

This will be explained using the schematic diagram of a manufacturing apparatus illustrated in Fig. 9. The roll film of the plastic film (2) to be the substrate is set on an unwinding roll (9). The plastic film (2) runs along a guide roll (10) and over a coating roll (11).

Aluminum in a crucible (12) is heated and evaporated by the electron beam irradiated from an electron gun (19). The aluminum becomes a gas and flies upwards. On the way, oxygen gas is blown in from a nozzle (13) to conduct a reaction and form an alumina layer on the plastic film (2) running on the coating roll (11).

Together with aluminum vapor, a large number of reflected electrons and secondary electrons are emitted from the crucible (12) at the same time. Some of the emitted electrons electrically charge the plastic film (2) on the coating roll (11). When the plastic film is peeled off from the coating roll (11) in this state, the charged electrons are discharged and the alumina layer and the plastic film get damage.

An electric charge removing device (14) using a conductor and an electric charge removing device (15) using a plate electrode of the present invention are installed on the coating roll (11) to remove charged electrons. In order to reduce the peeling electrification when the plastic film (2) is peeled off from the coating roll (11), a negative electrode (16) is installed near the peeling off point to generate plasma.

The plastic film (2) that has left the coating roll (11) passes through an optical film thickness meter (17) and is wound around a winding roll (18). The optical film thickness meter (17) measures the light transmittance of the plastic film (2) passing therethrough to measure the film thickness of the laminated alumina layer. In order to control the film thickness to the intended film thickness, the electron beam that is the output of the electron gun (13) is controlled and the amount of aluminum evaporated from the crucible is controlled.

The coating roll (11) in this description corresponds to the metal roll (3) installed on the side of the plastic film opposite to the side on which the conductor is installed.

### EXAMPLES

Hereinafter, the present invention will be specifically described with reference to Examples, but the present invention is not limited to Examples.

### Example 1

A transparent barrier film was fabricated using a roll-to-roll electron beam heating reactive vapor deposition apparatus illustrated in the schematic diagram of the manufacturing apparatus illustrated in Fig. 9.

Toyobo Ester^{®} Film E5100 with a thickness of 12 µm manufactured by Toyobo Co., Ltd. was used as the plastic film (2).

Aluminum (purity 3 N) was placed in the alumina crucible (12) and heated with an electron beam to be evaporated.

Oxygen gas was introduced 16800 sccm from the nozzle (13) and reacted with the aluminum vapor to laminate an alumina layer on the plastic film (2) running on the coating roll (11) set at -20°C.

The plastic film was run at 8 m/sec.

After lamination of the alumina layer, the plastic film (2) was subjected to electric charge removal by the electric charge removing device (14) using the conductor (1), further subjected to electric charge removal by the electric charge removing device (15) using the plate electrode (7), and then separated from the coating roll (11). The negative electrode (16) was installed at the position where the plastic film (2) was separated from the coating roll (11) to prevent peeling electrification. The conditions for electric charge removal are shown in Table 1.

The conductor (1) is a fabric obtained by weaving fibers obtained by spinning short fibers of several tens of micrometers and chemical fibers and laminated with a metal, with fibers of about 5 mm extending in the form of a blind on the plastic film side. The distance between the plastic film and the fiber tip of the blind was kept at 3 mm.

The radius of curvature is 100 µm or less since fibers obtained by spinning short fibers of several tens of µm are used.

The plate electrode (7) was made of stainless steel, and a magnet was installed on the back surface to confine plasma. Water was allowed to flow on the back surface for cooling. The power supply was a direct current power supply with the positive side grounded and the negative side connected to the plate electrode.

The negative electrode (16) is a stainless steel cylinder, which is cooled by allowing water to flow inside. The power supply was a direct current power supply with the positive side grounded and the negative side linked to the cylindrical electrode.

The light transmittance of the plastic film (2) laminated with an alumina layer in the vicinity of 365 nm was measured using the optical film thickness meter (17), and controlled to the intended light transmittance of 83%.

The laminated plastic film (2) was wound around the winding roll (18). A sample was taken from the winding roll and observed from the alumina layer side using a differential interference microscope to examine the presence or absence of discharge trace. The results are shown in Table 1.

### Example 2

In Example 1, the distance between the fiber tip of the fabric blind of the conductor and the plastic film was changed to 5 mm. The pressure between the conductor and the plastic film was also changed as shown in Table 1. The presence or absence of discharge trace on the vapor-deposited transparent alumina barrier film was examined.

### Comparative Example 1

Vapor deposition was performed under the same conditions as those in Example 1 except that Ar gas was not introduced into the electric charge removing device using a conductor. The presence or absence of discharge trace on the vapor-deposited transparent alumina barrier film was examined.

### Comparative Example 2

In Example 1, the pressure between the conductor and the plastic film was changed as shown in Table 1. The presence or absence of discharge trace on the vapor-deposited transparent alumina barrier film was examined.

### Comparative Example 3

Vapor deposition was performed without installing the electric charge removing device using a conductor. In order to improve the peeling off of the plastic film from the coating roll, the discharge current of the electric charge removing device using a negative electrode was set to 0.65 A. The presence or absence of discharge trace on the vapor-deposited transparent alumina barrier film was examined.

**[Table 1]**

| | Electric charge removing device using conductor | | | Electric charge removing device using plate electrode | | | Electric charge removing device using negative electrode | | | Discharge trace |
|---|---|---|---|---|---|---|---|---|---|---|
| | Installation distance (mm) | Ar gas amount (sccm) | Pressure (Pa) | Ar gas amount (sccm) | Discharge current (A) | Discharge voltage (V) | Ar gas amount (sccm) | Discharge current (A) | Discharge voltage (V) | |
| Example 1 | 3 | 3000 | 9.1 | 2000 | 26 | 553 | 3000 | 0.40 | 441 | Absence |
| Example 2 | 5 | 6000 | 11.2 | 2000 | 26 | 528 | 2510 | 0.40 | 455 | Absence |
| Comparative Example 1 | 3 | 0 | 6.3 | 2000 | 26 | 583 | 3000 | 0.40 | 442 | Presence |
| Comparative Example 2 | 3 | 1500 | 7.5 | 2000 | 26 | 563 | 3000 | 0.40 | 463 | Presence |
| Comparative Example 3 | | | | 2000 | 26 | 580 | 3000 | 0.65 | 518 | Presence |

### INDUSTRIAL APPLICABILITY

According to the present invention, it is possible to provide a method for manufacturing a processed plastic film, which includes s step including an electric charge removing method in which an electric charge can be easily removed and damage to the plastic film due to electric discharge can be prevented in a case where a plastic film is processed while being run in a vacuum.

### DESCRIPTION OF REFERENCE SIGNS

- 1: Conductor
- 2: Plastic film
- 3: Roll
- 4: Nozzle
- 5: Wall
- 6: Vacuum chamber
- 7: Plate electrode
- 8: Wall
- 9: Unwinding roll
- 10: Guide roll
- 11: Coating roll
- 12: Crucible
- 13: Nozzle
- 14: Electric charge removing device using conductor
- 15: Electric charge removing device using plate electrode
- 16: Negative electrode
- 17: Optical film thickness meter
- 18: Winding roll
- 19: Electron gun

## Claims

1. A method for manufacturing a processed plastic film, the method comprising a step (step 1) of removing an electric charge by an electric charge removing method in which a conductor having a radius of curvature of 1 mm or less is installed in a transverse direction of a plastic film near the plastic film, a shortest distance between a plastic film surface and the conductor is set to 2 mm or more and 10 mm or less, a pressure between the plastic film surface and the conductor is kept at 8 Pa or more and 800 Pa or less, and the grounded conductor is used as a method for reducing a quantity of electric charge of a plastic film running in a vacuum.

2. The method for manufacturing a processed plastic film according to claim 1, comprising a step (step 2) of removing an electric charge from the plastic film by installing a device that connects a negative potential or an alternating current potential with a high frequency to a plate electrode, allows gas to flow between the plate electrode and the plastic film to generate plasma, and removes an electric charge by the generated plasma subsequently to the step 1.

3. The method for manufacturing a processed plastic film according to claim 1 or 2, comprising a step of installing a metal roll on a side of the plastic film opposite to a side on which the conductor is installed, grounding the metal roll, and removing an electric charge while running the plastic film over the metal roll.

4. A method for manufacturing a processed plastic film, the method comprising the steps according to claim 1, 2 or 3 in a manufacturing method for providing a vapor-deposited layer on a plastic film.
